# EUROPEAN PATENT APPLICATION

(11) **EP 4 726 814 A1**
(43) Date of publication of application: **15.04.2026**
(21) Application number: 24818666.0
(22) Date of filing: 05.06.2024
(51) Int. Cl.: H01M 4/66, H01M 4/64

(54) **COMPOSITE CURRENT COLLECTOR, MANUFACTURING METHOD THEREFOR, ELECTRODE SHEET AND BATTERY**

(30) Priority: 06.06.2023 CN 202310659854
(71) Applicant: REPT BATTERO Energy Co., Ltd., Wenzhou, Zhejiang 325000 (CN); Shanghai Ruipu Energy Co., Ltd., Shanghai 201206 (CN)
(72) Inventor: CAO, Hui, Wenzhou, Zhejiang 325000 (CN); SHAO, Xuexiang, Shanghai 201206 (CN); HOU, Min, Shanghai 201206 (CN); LI, Tingting, Shanghai 201206 (CN); LIU, Chan, Shanghai 201206 (CN)
(74) Representative: Vitina, Maruta
(86) International application number: PCT/CN2024/097435
(87) International publication number: WO 2024/251134

(57) **Abstract**

The present invention relates to a composite current collector and its preparation method, electrodes, and batteries. The composite current collector includes an insulating substrate, a first metal layer set on both surfaces of the thickness direction of the insulating substrate, and a second metal layer set on the surface away from the insulating substrate on the first metal layer. Multiple colloidal particles are attached to the surface of the first metal layer away from the insulating substrate, with the colloidal particles evenly distributed. The second metal layer is set on the first metal layer, and the second metal layer encapsulates the evenly distributed colloidal particles. By setting the composite current collector with specific structures of the colloidal particles, it overcomes the issues of low electrode peel strength and capacity drop in long cycle batteries, significantly enhancing the stability of long cycle battery electrodes.

## Description

### TECHNICAL FIELD

The present invention belongs to the field of battery current collector manufacturing technology, and involves a composite current collector and its preparation method, electrode and battery.

### BACKGROUND TECHNOLOGY

At present, aluminum foil or electrolytic copper foil is still the most widely used battery current collector. The thinness of aluminum foil or copper foil is the main direction of industrial technology upgrading.

Taking copper foil as an example, composite copper foil is a good alternative material to the traditional battery anode current collector. The reduced metal content in composite copper foil is partially replaced by polymer film materials, making it lighter overall. This has significant implications for improving battery energy density, enhancing safety, and reducing costs. Similarly, composite aluminum foil is also an excellent alternative material to the traditional battery cathode current collector. The reduced metal content in composite aluminum foil is similarly replaced by polymer film materials, resulting in a lighter overall weight and improved safety.

Current composite copper foils or composite aluminum foils typically consist of copper metal layers or aluminum metal layers coated on both sides of a polymer film. For example, CN115094384A discloses a copper composite current collector and its preparation method and application. The preparation method for the copper composite current collector includes the following steps: providing a polymer film; using vacuum evaporation technology to pass the polymer film through a copper-coating roller, which is divided into a first temperature zone and a second temperature zone along the axial direction of the roller, with the temperature in the first zone being 40°C to 50°C and in the second zone being 10°C to 20°C; and evaporating metallic copper under vacuum conditions to coat the two sides of the polymer film with copper metal layers. The copper composite current collector prepared by this method has a high specific surface area and can reduce the interface resistance of batteries.

However, the surface roughness of composite copper foil or composite aluminum foil is low, and it is difficult to achieve high peel strength of the electrode. The continuous expansion and contraction during the charging and discharging process of the battery can easily cause the active material to fall off from the current collector, resulting in rapid capacity decay of the battery.

How to overcome the low peel strength of the electrode with composite current collector and solve the problem of capacity drop of long cycle battery is a technical problem that needs to be solved urgently in the field of current collector for secondary batteries.

### SUMMARY OF THE INVENTION

In view of the issues present in existing technologies, the present invention provides a composite current collector and its preparation method, electrodes, and batteries. By setting up two metal layers, dispersed colloidal particles are attached to the surface of the first metal layer, with the colloidal particles evenly distributed. The second metal layer is placed on top of the first metal layer, and it wraps around the dispersed colloidal particles. Through the composite current collector formed by the specific structure of the colloidal particles, the present invention overcomes the problems of low electrode peel strength and significant capacity drop in long cycle batteries, significantly enhancing the stability of long cycle battery electrodes.

To achieve this purpose, the present invention adopts the following technical solutions:
In a first aspect, the present invention provides a composite current collector, which comprises an insulating substrate, a first metal layer provided on both surfaces in the thickness direction of the insulating substrate, and a second metal layer provided on the surface of the first metal layer away from the insulating substrate;
The first metal layer has a plurality of spaced-apart colloidal particles attached to the surface of the side of the first metal layer away from the insulating substrate.

In some embodiments, the colloidal particles are attached to the surface of the first metal layer, at least a portion of each colloidal particle is located in the second metal layer; and along the thickness direction of the insulating substrate, at least a portion of each colloidal particle is exposed to the surface of the second metal layer away from the insulating substrate.

It should be noted that "multiple" in the present invention refers to "two or more". The colloidal particles in the present invention refer to colloidal particles formed into specific granular shapes by polymer materials. For example, they can be rectangular blocks of polymer material.

The present invention sets up two metal layers, with dispersed particles attached to the surface of the first metal layer. The particles are evenly distributed and the second metal layer is placed on top of the first, enveloping the dispersed particles. By forming a composite current collector through the specific structure of the particles, the particles help enhance the adhesion between the current collector and the active material, overcoming issues such as low electrode peel strength and capacity drop in long cycle batteries, significantly improving the stability of the electrode in long cycle batteries.

Preferably, the thickness of the insulating substrate is 1 to 20µm, for example, it can be 1 µm, 2µm, 3µm, 4µm, 5µm, 6µm, 7µm, 8µm, 9µm, 10µm, 15µm or 20µm, but not limited to the listed values, other unlisted values within the range are also applicable.

Preferably, along the thickness direction of the insulating substrate, the thickness of the first metal layer located on one side of the insulating substrate is 0.1 to 500nm, for example, it can be 0.1nm, 1nm, 2nm, 5nm, 10nm, 20nm, 50nm, 100nm, 200nm or 500nm, but not limited to the listed values, other unlisted values within the range are also applicable.

Preferably, along the thickness direction of the insulating substrate, the thickness of the second metal layer located on the side of the first metal layer away from the insulating substrate is 0.05 to 3µm, for example, it can be 0.05µm, 0.1µm, 0.5µm, 0.8µm, 1µm, 1.5µm, 2µm, 2.5µm, or 3µm. However, this is not limited to the listed values; other values within the range are also applicable. If the thickness of the second metal layer is too large and completely covers the colloidal particles, it will reduce the peel strength and decrease the mass energy density and long cycle capacity stability of the battery.

Preferably, along the thickness direction of the insulating substrate, the thickness ratio of the first metal layer and the second metal layer located on the same side of the insulating substrate is 1:(6~30000), for example, it can be 1:6, 1:300,1:3000,1:10000 or 1:30000, but not limited to the listed values, other unlisted values within the range are also applicable.

In the composite current collector of the present invention, the insulating substrate is non-conductive, while the two metal layers (the first and second metal layers) are conductive. Preferably, the thickness of the insulating substrate is greater than the total thickness of the two layers of the first metal layer and the two layers of the second metal layer on both sides of the insulating substrate. This results in fewer burrs, thereby reducing the risk of increased resistance in batteries made from this composite current collector.

Preferably, the metal materials of the first and second metal layers independently include any one or at least two combinations of gold, silver, copper, zinc, chromium, aluminum, nickel, and tungsten. Typical but non-limiting combinations include the combination of gold and silver, silver and copper, copper and zinc, zinc and chromium, chromium and aluminum, aluminum and nickel, the combination of gold, silver, and copper, the combination of silver, copper, and zinc, the combination of copper, zinc, and chromium, the combination of zinc, chromium, and aluminum, and the combination of chromium, aluminum, and nickel. In some embodiments, the material of the first and second metal layers is copper. In other embodiments, the material of the first and second metal layers is aluminum.

Preferably, the purity of the metal in the first metal layer and the second metal layer is independently ≥99.8%, for example, it can be 99.8%, 99.85%, 99.9%, 99.95% or 100%, but not limited to the listed values, other unlisted values within the range are also applicable.

Preferably, the insulating substrate comprises an insulating polymer.

In the present invention, non-conductive insulating polymer is used as the insulating substrate to replace part of the metal layer material, so that the composite current collector is smaller in mass than traditional copper foil and other metal foil materials, thus effectively improving the energy density of the battery.

Preferably, the insulating polymer includes any one or a combination of at least two of the following: cellulose, cellulose derivatives, starch, starch derivatives, proteins, protein derivatives, polyvinyl alcohol, cross-linked polymers of polyvinyl alcohol, polyethylene glycol, cross-linked polymers of polyethylene glycol, polyamides, polybutylene terephthalate, polyimide, polyethylene, polypropylene, polystyrene, polyvinyl chloride, aramid, poly(p-phenylene terephthalamide), acrylonitrile-butadiene-styrene copolymer, polyethylene terephthalate, polybutylene terephthalate, polybenzidine, polypropylene, polyformaldehyde, epoxy resin, phenolic resin, polytetrafluoroethylene, polyvinylidene fluoride, silicone rubber, and polycarbonate. Preferably, it includes polybenzidine and/or polypropylene.

Preferably, the material of the colloidal particles includes any one or a combination of at least two of styrene-butadiene rubber, polytetrafluoroethylene, polyvinylidene fluoride, polyolefin, polyacrylic acid, polyacrylonitrile, fluororubber, and polyurethane. Typical but non-limiting combinations include the combination of styrene-butadiene rubber and polytetrafluoroethylene, polytetrafluoroethylene and polyvinylidene fluoride, polyvinylidene fluoride and polyolefin, polyolefin and fluororubber, fluororubber and polyurethane, the combination of styrene-butadiene rubber, polytetrafluoroethylene, and polyvinylidene fluoride, the combination of polytetrafluoroethylene, polyvinylidene fluoride, and polyolefin, the combination of polyvinylidene fluoride, polyolefin, and fluororubber, and the combination of polyolefin, fluororubber, and polyurethane, with the preferred combination being styrene-butadiene rubber and polyacrylic acid. In some embodiments, the material of the colloidal particles is polytetrafluoroethylene, or styrene-butadiene rubber, or a combination of styrene-butadiene rubber and polyacrylic acid. When the material of the colloidal particles is a combination of styrene-butadiene rubber and polyacrylic acid, the mass ratio of styrene-butadiene rubber to polyacrylic acid can be 10:1 to 1:1, for example, it can be 9:1, 8:1, 7:1, 6:1, 5:1, 4:1, 3: 1, or 2:1, but is not limited to these values; other values within the range are also applicable.

Preferably, the height of each of the colloidal particles in the thickness direction of the composite current collector is 0.1 to 10µm, for example, 0.2µm, 0.5µm, 1µm, 1.2µm, 1.5µm, 1.8µm, 2µm, 2.5µm, 2.7µm, 3µm, 3.2µm, 4µm, 5µm, 6µm, 7µm, 8µm, or 9µm, but not limited to the listed values, other unlisted values within the range are also applicable.

Preferably, the size of each of the colloidal particles in the length direction of the composite current collector is 38 to 150µm, for example, it can be 38µm, 40µm, 45µm, 48µm, 50µm, 60µm, 70µm, 75µm, 80µm, 90µm, 100µm, 110µm, 120µm, 130µm, 140µm, or 150µm, but not limited to the listed values, other unlisted values within the range are also applicable.

Preferably, the size of each of the colloidal particles in the width direction of the composite current collector is 38 to 1 50µm, for example, it can be 38 um, 40µm, 45µm, 48µm, 50µm, 60µm, 70µm, 75µm, 80µm, 90µm, 100µm, 110µm, 120µm, 130µm, 140µm, or 150µm, but not limited to the listed values, other unlisted values within the range are also applicable.

The size of the colloidal particles in both the length and width directions of the composite current collector should be within the aforementioned range. This helps to ensure that the electrode has high peel strength and that the battery has a high mass energy density and good long-term cycle capacity stability. If the size of the colloidal particles is too large in either direction, it will reduce the peel strength of the electrode and decrease the mass energy density and long-term cycle capacity stability of the battery. Conversely, if the size of the colloidal particles is too small in either direction, it will also reduce the peel strength of the electrode and lower the long-term cycle capacity stability of the battery.

Preferably, the density of the particles attached to the first metal layer is 100 to 400 particles per square inch, for example, 100 particles per square inch, 150 particles per square inch, 200 particles per square inch, 300 particles per square inch, 350 particles per square inch or 400 particles per square inch, but not limited to the listed values, other unlisted values within the range are also applicable.

Preferably, the colloidal particles are attached to the surface of the first metal layer, at least a portion of each colloidal particle is placed in the second metal layer; and along the thickness direction of the insulating substrate, at least a portion of each colloidal particle is exposed to the surface of the second metal layer away from the insulating substrate.

It should be noted that "at least a portion of each colloidal particle is exposed to the surface of the second metal layer away from the insulating substrate" means that each colloidal particle is not completely covered by the second metal layer along the thickness direction of the insulating substrate.

In a second aspect, the present invention provides a preparation method of the composite current collector according to the first aspect, which includes the following steps:
(1) Deposit a first metal layer on at least one surface in the thickness direction of the insulating substrate;
(2) Roll the colloidal solution on the surface of the first metal layer away from the insulating substrate so as to attach and form colloidal particles on the surface of the first metal layer;
(3) Deposit a second metal layer on the surface of the first metal layer attached to the side away from the insulating substrate to obtain the composite current collector.

Preferably, the colloidal solution comprises a solution in which the colloidal particles are dispersed in a solvent. The solvent of the colloidal solution can be water.

Preferably, the roller coating in step (2) is carried out by a mesh roller.

Preferably, the mesh number of the mesh roller is 100 to 400, for example, it can be 100, 200, 300, 350 or 400, but not limited to the listed values, other unlisted values within the range are also applicable.

According to the mesh number of the mesh roller, colloidal particles of different sizes are obtained in the mesh roller to form the colloidal particles.

Preferably, the deposition in step (1) is carried out by vacuum evaporation.

Preferably, the deposition in step (3) is carried out by electroplating.

In the present invention, the second metal layer is deposited using electroplating. On one hand, this method helps increase the thickness of the second metal layer. On the other hand, at the positions where colloidal particles are attached on the surface of the first metal layer, since these particles are insulating materials and do not conduct electricity, they do not participate in the electroplating process. As a result, the colloidal particles are embedded in the second metal layer and are encapsulated by it, but they are not completely covered by the second metal layer.

The reason why the particles are not completely covered by the second metal layer is that if the particles are completely covered by the second metal layer, the peel strength of the composite current collector will decrease.

In a third aspect, the present invention provides an electrode containing the composite current collector as described in the first aspect.

In a fourth aspect, the present invention provides a battery containing the composite current collector or the electrode as described in the first aspect or the third aspect.

Preferably, the battery comprises any one of a lithium ion battery, a sodium ion battery or a potassium ion battery or a combination of at least two of them.

According to the above technical solution, the beneficial effects of the present invention are as follows:
(1) The present invention sets up two metal layers, with dispersed particles attached to the surface of the first metal layer. The particles are evenly distributed. A second metal layer is placed on top of the first metal layer, and this second layer envelops the dispersed particles. By forming a composite current collector through the specific structure of the particles, it overcomes the issues of low electrode peel strength and significant capacity drop in long cycle batteries, significantly enhancing the stability of the electrodes in long cycle batteries.
(2) In the present invention, non-conductive insulating polymer is used as the insulating substrate to replace part of the metal layer material, so that the composite current collector is smaller in mass than the traditional copper foil or aluminum foil and other metal foil materials, thus effectively improving the energy density of the battery.

### ILLUSTRATIVE DRAWINGS

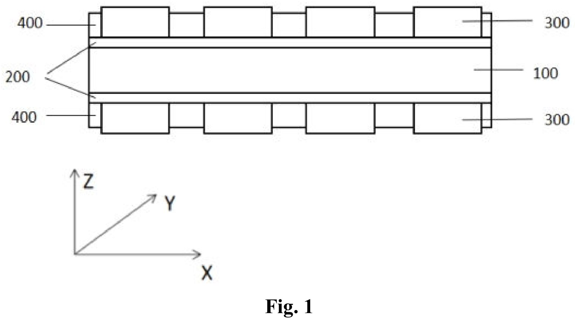

Figure 1 is a schematic diagram of the structure of the composite current collector described in Example 1.

Among them, 100-insulating substrate, 200-first metal layer, 300-colloidal particle, and 400-second metal layer.

### DETAILED DESCRIPTION

The technical solution of the present invention will be further described below with reference to the accompanying drawings and specific embodiments. However, the following examples are merely simple instances of the present invention and do not represent or limit the scope of protection of the present invention. The scope of protection of the present invention is defined by the claims.

It should be noted that, for the ease of understanding the technical solution of the present invention, as illustrated in Figure 1, the X direction is set as the length direction of the composite current collector, the Y direction as the width direction, and the Z direction as the thickness direction; where the X direction, Y direction, and Z direction are mutually perpendicular. The thickness direction of the insulating substrate is the same as the thickness direction of the composite current collector; the insulating substrate, the first metal layer, and the second metal layer each have their own thickness in the thickness direction of the composite current collector, and the particles have a certain height in the thickness direction of the composite current collector.

### Example 1

This embodiment provides a composite current collector (as schematically shown in Figure 1). The composite current collector includes an insulating substrate 100 and a first metal layer 200 set on both the upper and lower surfaces of the insulating substrate 100. That is, two layers of the first metal layer 200 are formed along the thickness direction of the insulating substrate 100. The composite current collector also includes a second metal layer 400 set on each layer of the first metal layer 200. Each layer of the first metal layer 200 has uniformly dispersed colloidal particles 300 attached to its surface away from the insulating substrate 100, which are encapsulated by the second metal layer 400 but not completely covered: each colloidal particle 300 has a height of approximately 2.7µm.

The material of the insulating substrate 100 is poly(p-phenylene terephthalamide), and the thickness of the insulating substrate 100 is 4µm.

The first metal layer 200 is a copper layer, the purity of which is ≥99.8%, and the thickness of each first metal layer 200 is 10nm.

The material of the colloidal particle 300 is polytetrafluoroethylene, and the size of each colloidal particle 300 in the length direction and width direction of the composite current collector is about 75µm. The density of the colloidal particle 300 attached to the first metal layer 200 is 200 per square inch.

The second metal layer 400 is a copper layer, the purity of which is ≥99.8%, and the thickness of each second metal layer 400 is 1.5µm.

The composite current collector is prepared by the following method:
The insulating substrate 100 is vacuum evaporated to obtain a first metal layer 200 disposed on the upper surface and lower surface of the insulating substrate 100;
The polytetrafluoroethylene aqueous solution (the solid content of the polytetrafluoroethylene aqueous solution is 60wt%) is coated on the surface of each first metal layer 200 by a mesh roller, and the mesh number of the mesh roller is 200;
The second metal layer 400 is electroplated and deposited on the first metal layer 200 of the colloidal particle 300 to obtain the composite current collector.

### Example 2

This embodiment provides a composite current collector, which is different from Example 1 in that the material of the insulating substrate 100 is polypropylene, and the thickness of each second metal layer 400 is 1.9µm, the mesh number of the mesh roller is 100, the dimensions of each colloidal particle 300 in both the length and width directions of the composite current collector are approximately 150µm, and the height of each colloidal particle 300 is approximately 3.2µm.

### Example 3

This embodiment provides a composite current collector, which is different from Example 1 in that the size of each colloid particle 300 in both the length and width directions of the composite current collector is about 48µm, and the height of each colloid particle 300 is about 1.8µm. In the preparation method, the mesh number of the mesh roller is 300, and the thickness of each second metal layer 400 is 1µm.

### Example 4

This embodiment provides a composite current collector, which is different from Example 1 in that the colloid solution is styrene-butadiene rubber aqueous solution (in which the solid content of styrene-butadiene rubber aqueous solution is 50wt%), that is, the material of colloid particle 300 is replaced by styrene-butadiene rubber of equal mass instead of polytetrafluoroethylene.

### Example 5

This embodiment provides a composite current collector, which is different from Example 1 in that the material of the colloid particle 300 is replaced by an equal mass of styrene-butadiene rubber and polyacrylic acid, wherein the mass ratio of styrene-butadiene rubber to polyacrylic acid is 3:1.

### Example 6

This embodiment provides a composite current collector, which is different from Example 1 in that the thickness of the insulating substrate 100 is 10µm.

### Example 7

This embodiment provides a composite current collector, which is different from Example 1 in that the size of each colloid particle 300 in the length direction and width direction of the composite current collector is about 1700µm, and the height of each colloid particle 300 is about 5µm. In the preparation method, the mesh number of the mesh roller is 10.

### Example 8

This embodiment provides a composite current collector, which is different from Example 1 in that the size of each colloid particle 300 in the length direction and width direction of the composite current collector is about 18µm, and the height of each colloid particle 300 is about 1.2µm. In the preparation method, the mesh number of the mesh roller is 800.

### Example 9

This embodiment provides a composite current collector, which is different from Example 1 in that the thickness of the second metal layer is 6µm.

### Example 10

This embodiment provides a composite current collector, which is different from Example 1 in that: the first metal layer 200 is an aluminum layer with a purity of aluminum ≥99.8%; and the second metal layer 400 is an aluminum layer with a purity of aluminum ≥99.8%.

### Comparative Example 1

This embodiment provides a composite current collector, which is different from Example 1 in that it does not contain colloidal particles.

The composite current collector obtained from Examples 1-9 and Comparative Example 1 is coated with a negative active material layer to form the anode. Then, the anode is assembled with the cathode and separator to form the battery for testing. The composition of the negative active material layer includes graphite, conductive carbon black (SP), sodium carboxymethyl cellulose, and styrene-butadiene rubber; and the ratio of graphite:SP:sodium carboxymethyl cellulose:styrene-butadiene rubber in the negative active material layer is 96.2:0.8:1.2:1.8 (all by mass).

The cathode is a conventional cathode composed of a layer of positive active material coated on the surface of aluminum foil, where the composition of the positive active material layer includes LiNi_{0.8}Co_{0.1}Mn_{0.1}O₂ (NCM811), SP, carbon nanotubes (CNT), and polyvinylidene fluoride (PVDF); and the ratio of NCM811:SP:CNT:PVDF in the positive active material layer is 97.2:1.1:0.6:1.1 (all by mass).

The separator is composed of 9µm PE base membrane+3µm AlOOH coating+0.5µm PVDF glue layer composite separator;
The solvent of the electrolyte is ethylene carbonate and dimethyl carbonate in a volume ratio of 1:1, the additive in the electrolyte is fluorinated ethylene carbonate accounting for 10% of the total mass of the electrolyte, and the lithium salt in the electrolyte is lithium hexafluorophosphate (concentration of 1mol/L).

The composite current collector obtained from Example 10 is coated with a positive active material layer to form a cathode. This cathode is then assembled with separator and anode to construct a battery for testing. The positive active material layer consists of NCM811, SP, CNT, and PVDF; and the ratio of NCM811:SP:CNT:PVDF in the positive active material layer is 97.2:1.1:0.6:1.1 (all by mass).

Among them, the anode is a conventional anode composed of an electrolytic copper foil coated with a layer of negative active material. The composition of the negative active material layer includes graphite, SP, sodium carboxymethyl cellulose, and styrene-butadiene rubber; and the ratio of graphite:SP:sodium carboxymethyl cellulose:nitrile butadiene rubber in the negative active material layer is 96.2:0.8:1.2:1.8 (all by mass).

The separator is composed of 9µm PE base membrane+3µm AlOOH coating+0.5µm PVDF glue layer composite separator;

The solvent of the electrolyte is ethylene carbonate and dimethyl carbonate in a volume ratio of 1:1, the additive in the electrolyte is fluorinated ethylene carbonate accounting for 10% of the total mass of the electrolyte, and the lithium salt in the electrolyte is lithium hexafluorophosphate (concentration of 1mol/L).

Peel strength test: First, cut the anodes and cathodes obtained from the above examples and control samples into strips that are 24mm wide and 150mm long. Then, attach one end of each cut anode or cathode to a stainless steel plate, which is fixed on one fixture of a tensile testing machine. The other fixture of the testing machine holds the free end of the anode or cathode. The anode or cathode is positioned at a 180° angle to the stainless steel plate. Pull the anode or cathode at a rate of 20 mm/min. Measure the force required to continuously peel the adhesive tape from the stainless steel plate to determine the peel strength.

Mass energy density calculation: Battery Energy Density = Battery Capacity × Discharge Platform Voltage / Mass of the Battery. The method for calculating battery capacity is as follows: at 25°C, first charge with constant current and voltage: charge to 4.2V at 0.33C, stop charging at 0.05C, and rest 5min; then discharge with constant current: discharge to 2.8V at 0.33C, and rest 10min; after three cycles, use the average of the three cycle discharge capacities as the battery capacity. The discharge platform voltage for each battery in the embodiments is 3.7V.

Cycle performance test: Place the batteries obtained from the above embodiments and rest 5 min, then discharge at 1C constant current to 2.0V, rest 10 min; charge at 1C constant current to 3.65V, 3.65V constant voltage until 0.05C, rest 5 min; discharge at 1C constant current to 2.0V, rest 10 min. Repeat the process of charging at 1C constant current to 3.65V, 3.65V constant voltage until 0.05C, rest 5 min; discharge at 1C constant current to 2.0V, rest 10 min, until the capacity drops below 80%, record the number of cycles at this point.

The test results are shown in Table 1.

**Table 1**

| Test number | Electrode peel strength (N/m) | Mass energy density (Wh/kg) | Cycle performance (number of cycles remaining 80% of capacity) |
|---|---|---|---|
| Example 1 | 19.5 | 207 | 1354 |
| Example 2 | 17.0 | 204 | 1392 |
| Example 3 | 17.3 | 220 | 1235 |
| Example 4 | 18.2 | 207 | 1357 |
| Example 5 | 24.5 | 205 | 1423 |
| Example 6 | 18.9 | 198 | 1351 |
| Example 7 | 14.5 | 190 | 945 |
| Example 8 | 10.2 | 205 | 920 |
| Example 9 | 9.8 | 185 | 960 |
| Example 10 | 30.1 | 210 | 1356 |
| Comparative Example 1 | 8.1 | 218 | 962 |

The present invention sets up two metal layers, with dispersed colloidal particles attached to the surface of the first metal layer. The colloidal particles are evenly distributed. A second metal layer is placed on top of the first metal layer, and this second layer envelops the dispersed colloidal particles. By forming a composite current collector through the specific structure of the colloidal particles, it overcomes the issues of low peel strength and capacity drop in long cycle batteries, significantly enhancing the stability of the electrode in long cycle batteries.

The present invention is described through the above embodiments to illustrate its detailed structural features. However, the present invention is not limited to these detailed structural features; it does not mean that the present invention must rely on these detailed structural features for implementation. Those skilled in the relevant technical field should understand that any improvements to the present invention, equivalent substitutions of components selected for the present invention, additions of auxiliary components, and choices of specific methods all fall within the scope of protection and disclosure of the present invention.

## Claims

1. A composite current collector, **characterized in that** the composite current collector comprises an insulating substrate, a first metal layer provided on both surfaces in the thickness direction of the insulating substrate, and a second metal layer provided on the surface of the first metal layer away from the insulating substrate;
The first metal layer has a plurality of spaced-apart colloidal particles attached to the surface of the side of the first metal layer away from the insulating substrate.

2. The composite current collector according to claim 1, **characterized in that** the thickness of the insulating substrate is 1 to 20µm;
In the thickness direction of the insulating substrate, the thickness of the first metal layer located on one side of the insulating substrate is 0.1 to 500nm;
In the thickness direction of the insulating substrate, the thickness of the second metal layer located on the side of the first metal layer away from the insulating substrate is 0.05 to 3µm.

3. The composite current collector according to claim 1, **characterized in that** the metal material of the first and second metal layers independently includes any one or at least two combinations of gold, silver, copper, zinc, chromium, aluminum, nickel and tungsten.

4. The composite current collector according to claim 1, **characterized in that** the material of the colloidal particles comprises any one or a combination of at least two of styrene-butadiene rubber, polytetrafluoroethylene, polyvinylidene fluoride, polyolefin, polyacrylic acid, polyacrylonitrile, fluorinated rubber and polyurethane;
The density of the colloidal particles attached to the first metal layer is 100 to 400 per square inch.

5. The composite current collector according to claim 1, **characterized in that** the colloidal particles adhere to the surface of the first metal layer, with at least a portion of each colloidal particle located within the second metal layer; and along the thickness direction of the insulating substrate, at least a portion of each colloidal particle is exposed on the surface of the second metal layer away from the insulating substrate.

6. A method for preparing the composite current collector according to any one of claims 1 to 5, **characterized in that** the preparation method comprises the following steps:
(1) Deposit a first metal layer on at least one surface in the thickness direction of the insulating substrate;
(2) Roll the colloidal solution on the surface of the first metal layer away from the insulating substrate so as to attach and form colloidal particles on the surface of the first metal layer;
(3) Deposit a second metal layer on the surface of the first metal layer attached to the side away from the insulating substrate to obtain the composite current collector.

7. The preparation method according to claim 6, **characterized in that** the roller coating in step (2) is carried out by a mesh roller;
The mesh number of the mesh roller is 100~400 mesh.

8. The preparation method according to claim 6, **characterized in that** the deposition in step (1) is carried out by vacuum evaporation;
The deposition described in step (3) is carried out by electroplating.

9. An electrode, **characterized in that** the electrode contains a composite current collector as claimed in any one of claims 1 to 5.

10. A battery, **characterized in that** the battery contains a composite current collector as claimed in any one of claims 1 to 5 or an electrode as claimed in claim 9.
